# FASCICULE DE BREVET EUROPEEN

(11) **EP 0 327 420 B1**
(45) Date de publication et mention de la délivrance du brevet: **21.04.1993**
(21) Numéro de dépôt: 89400158.5
(22) Date de dépôt: 19.01.1989
(51) Int. Cl.: G01R 29/02, G01R 31/26

(54) **Dispositif et procédé de mesure d'une impulsion brève de rayonnement ou d'une impulsion brève électrique**
Vorrichtung und Verfahren zur Messung eines kurzen Lichtimpulses oder eines kurzen elektrischen Impulses
Device and method for measuring a short light pulse or a short electrical pulse

(30) Priorité: 22.01.1988 FR 8800694
(43) Date de publication de la demande: 09.08.1989
(73) Titulaire: COMMISSARIAT A L'ENERGIE ATOMIQUE, 75015 Paris Cédex 15 (FR); ORGANISATION EUROPEENNE POUR LA RECHERCHE NUCLEAIRE (CERN), 1211 Geneve 23 (CH)
(72) Inventeur: Cuzin, Marc, F-38700 La Tronche (FR); Rossa, Edouard, F-01170 Gex (FR)
(74) Mandataire: Mongrédien, André

(56) Documents cités:
- US-A- 4 482 863
- APPLIED PHYSICS LETTERS, Vol. 43, No. 7, Octobre 1983, pages 631-633, New Yortk, US; D.H. Auston et al.: "Generation and Detection of Millimeter Waves by Picosecond Photoconductivity"
- APPLIED PHYSICS LETTERS, Vol. 38, No. 1, Janvier 1981, pages 47-50, New York, US; P.R. Smith et al:: "Picosecond Photoconductivity in Radiation-Damaged Silicon-on Sapphire"
- APPLIED PHYSICS LETTERS, Vol. 37, No. 4, Aout 1980, pages 371-373, New York, US; D.H. Auston et al.: "Picosecond Optoelectronic detection, sampling, and correlation measurements in Amorphous Semiconductors"

## Description

### DISPOSITIF ET PROCEDE DE MESURE D'UNE IMPULSION BREVE DE RAYONNEMENT OU D'UNE IMPULSION BREVE ELECTRIQUE

L'invention a pour objet un dispositif et un procédé de mesure d'une impulsion brève de rayonnement ou d'une impulsion brève électrique utilisant un tel dispositif qui permet de connaître à partir d'une seule impulsion soit sa fonction d'auto-corrélation soit sa forme temporelle.

On entend par impulsions brèves des impulsions dont la durée peut aller de 1 à 1000 picosecondes. Lorsque l'impulsion à analyser est une impulsion brève mais répétitive, on procède classiquement à un échantillonnage de cette impulsion au moyen d'un oscilloscope à échantillonnage qui permet de prélever une partie de l'information à chaque impulsion et de construire ainsi par partie la forme de l'impulsion. On peut également procéder à une analyse par effet Josephson. Cette technique d'échantillonnage ne peut s'appliquer qu'à des impulsions répétitives.

On utilise aussi classiquement, dans le cas d'impulsions brèves mais non répétitives, une caméra à balayage de fente dans laquelle la visualisation du phénomène sur un tube à mémoire liée à une déflexion électronique a une révolution temporelle proche de la picoseconde pour des impulsions photoniques (rayon X, ultraviolet visible ou infrarouge). Cependant, l'utilisation d'une telle caméra à balayage de fente ne peut être facilement mise en oeuvre dans certaines utilisations à cause des dimensions géométriques importantes qu'elle présente. Par ailleurs, son coût est élevé. D'autre part, l'exploitation de l'image fournie est difficile car elle doit être reprise par une autre caméra.

Il est également connu d'utiliser un dispositif autocorrélateur électro-optique pour effectuer la mesure d'impulsion brève non répétitive ou répétitive mais cohérente. De tels autocorrélateurs utilisent des cristaux non linéaires qui permettent d'atteindre le domaine de la sub-picoseconde. Cependant de tels autocorrélateurs ne sont utilisables que pour des impulsions de lumière cohérente.

On connaît par ailleurs un autocorrélateur multivoies qui est réalisé à partir de photoconducteurs reliés à des lignes de propagation de signaux électriques générés par les photoconducteurs. Une présentation d'un tel autocorrélateur a été faite à San Diego en Août 1987. Cependant, un tel corrélateur ne permet pas de donner la forme d'une impulsion en monocoup c'est-à-dire à partir d'une impulsion unique dans le cas où l'impulsion est électrique. De plus, dans le cas d'impulsions électromagnétiques, ce dispositif ne peut être utilisé que pour une gamme prédéterminée de durées d'impulsions, le nombre limité de points de la fonction d'autocorrélation étant lié à une impulsion dont la durée moyenne est connue. Par ailleurs, ce dispositif qui a été présenté comporte autant de lignes à retard que de points de mesure de la fonction d'autocorrélation. Les différents photoconducteurs associés à chaque ligne à retard ne permettent en fait que des mesures temporelles très proches les unes des autres et permettent uniquement de connaître l'inclinaison du faisceau incident par rapport à son axe de propagation qui est supposé être perpendiculaire au plan des photoconducteurs détecteurs. Les différentes lignes à retard ont des longueurs différentes afin d'obtenir différents points de la fonction d'autocorrélation d'une impulsion.

Il est également connu par ailleurs, du brevet américain 4 482 863, un dispositif de mesure de la fonction de transfert d'un circuit, ce dispositif comportant une seule ligne à retard tout au long de laquelle sont disposés plusieurs éléments photoconducteurs. Ceux-ci sont espacés régulièrement sur la ligne à retard pour introduire des temps égaux de propagation de l'onde électrique circulant sur cette ligne entre les différents photoconducteurs. Ainsi, on obtient différents points de la forme temporelle d'une impulsion électrique répétitive.

Dans le dispositif décrit dans ce brevet, les éléments photoconducteurs et les lignes de propagation des signaux électriques sont réalisés en technologie de surface (ruban sur substrat). Ceci a l'inconvénient de limiter fortement les tensions de polarisation utilisables, faute de quoi l'ionisation de l'air entre les électrodes au voisinage des éléments photoconducteurs introduit un courant parasite pouvant introduire des claquages intempestifs. Cette limitation introduit une perte importante de la sensibilité qui explique la nécessité du fonctionnement avec des impulsions répétitives. Ce dispositif permet donc d'effectuer, par échantillonnage, l'analyse de l'impulsion électrique en introduisant de manière optique le retard nécessaire à la fonction d'échantillonnage.

De plus, il est nécessaire de lui associer une optique pour retarder l'arrivée de l'impulsion optique nécessaire pour l'analyse sur chacun des photoconducteurs.

Aucun dispositif simple de l'art antérieur ne permet donc d'obtenir soit l'analyse temporelle ou la fonction d'autocorrélation d'une impulsion brève, en monocoup, de rayonnement électromagnétique ou ionisant, soit la forme temporelle d'une impulsion électrique.

La présente invention a pour but de remédier à ces problèmes. Elle a pour objet un dispositif de mesure d'une impulsion brève unique comprenant au moins un ensemble de mesures apte à effectuer p points de mesure de l'impulsion de durée ϑ, comportant une ligne conductrice et un ensemble de photoconducteurs, la ligne et les photoconducteurs étant placés entre deux diélectriques, caractérisé en ce qu'à la ligne est relié par une de ses électrodes chacun des photoconducteurs de l'ensemble de photoconducteurs, la longueur de la ligne séparant deux photoconducteurs successifs est égale au produit de la vitesse de propagation sur cette ligne par le rapport ϑ/p, les photoconducteurs étant choisis de sorte que la durée de vie des porteurs majoritaires qui les constituent soit inférieure ou égale à 10% de la durée de l'impulsion à analyser. Le dispositif permet ainsi d'obtenir une analyse temporelle ou la fonction d'autocorrélation, soit d'une impulsion de rayonnement, soit d'une impulsion électrique.

L'invention a également pour objet un dispositif de mesure d'une impulsion comprenant une pluralité d'ensembles de mesure pour lesquels la durée de vie des porteurs majoritaires des photoconducteurs est différente d'un ensemble à un autre de manière à obtenir une sensibilité identique pour différentes durées d'impulsions.

L'invention a également pour objet un dispositif de mesure d'une impulsion brève dans lequel chaque ensemble de mesure comporte p+1 photoconducteurs dont la durée de vie τ des porteurs majoritaires est inférieure ou égale à 10% de ϑ, de manière à avoir p points de mesure pour une impulsion de durée ϑ .

Selon une réalisation particulière, le dispositif de mesure comporte un premier substrat comprenant une première face métallisée et une deuxième face opposée à la première sur laquelle sont disposées des pistes conductrices et une ligne conductrice sensiblement perpendiculaire aux pistes et espacée de ces dernières. Il comporte également un deuxième substrat placé sur les pistes et la ligne conductrice, ce deuxième substrat comprenant des orifices de longueur supérieure à l'espace qui réside entre la ligne conductrice et les pistes et étant recouvert d'une couche métallisée. Les photoconducteurs sont constitués par des pavés comprenant un substrat sur lequel sont déposés une couche semiconductrice puis un premier et un deuxième contacts placés sur la couche semiconductrice à chacune des extrémités du pavé, chaque pavé ayant des dimensions telles qu'il puisse être logé dans un orifice du deuxième substrat, un contact étant placé sur la ligne conductrice tandis que l'autre est placé sur une piste.

Selon un mode préféré de réalisation du dispositif de mesure, les photoconducteurs sont réalisés à partir d'une couche semiconductrice constituée par du tellurure de cadmium ou de l'arséniure de gallium ou du phosphure d'indium.

L'invention a également pour objet un procédé de mesure d'une impulsion dans lequel on utilise un dispositif de mesure selon l'invention et pour lequel la ligne conductrice est fermée en chacune de ses extrémités par son impédance caractéristique et dans lequel on envoie sur l'ensemble du dispositif une impulsion brève de rayonnement E(t), le premier photoconducteur étant polarisé par une tension continue prédéterminée, on envoie à travers la ligne un signal électrique S(t) image de l'impulsion incidente E(t) tel que S(t)=KE(t), le signal S(t) polarisant le deuxième photoconducteur qui génère un courant proportionnel au produit de convolution de l'impulsion E(t) et de son image retardée E₁(t), E₁(t)=E(t+x/v) où x est la longueur de la ligne séparant ces deux premiers photoconducteurs, v la vitesse de propagation sur la ligne, x étant choisi de sorte que le retard x/v soit égal à ϑ/p, avec des photoconducteurs dont la durée de vie des porteurs majoritaires est inférieure ou égale à 10% de ϑ; le signal S(t) polarisant de la même façon successivement tous les autres photoconducteurs avec un retard augmenté à chaque fois de ϑ/p, une charge Qi résultat de ces produits de convolution étant recueillie à la sortie de chaque photoconducteur, chaque charge donnant ainsi la mesure d'un point de la fonction d'autocorrélation de l'impulsion à mesurer.

L'invention a également pour objet un procédé de mesure d'une impulsion pour lequel on utilise le dispositif de l'invention, et dans lequel la ligne conductrice est fermée en ses deux extrémités par son impédance caractéristique ; dans lequel on envoie une impulsion brève de rayonnement à analyser éclairant tous les photoconducteurs et, en synchronisme avec cette impulsion, une impulsion de rayonnement plus brève de durée sensiblement égale ou inférieure à la durée de vie des porteurs majoritaires des photoconducteurs sur le premier photoconducteur, ce photoconducteur étant polarisé par une tension continue prédéterminée. Un ensemble de charges correspondant à un échantillonnage de l'impulsion de rayonnement à analyser est obtenu, chaque charge étant récupérée sur une électrode de sortie de chaque photoconducteur excepté le premier.

On peut également selon une variante procéder de façon inverse en envoyant une impulsion très brève de rayonnement sur tous les photoconducteurs et une impulsion brève de rayonnement à analyser sur le premier photoconducteur.

Ainsi on obtient la forme temporelle de l'impulsion à analyser avec une résolution temporelle qui est égale à la durée de vie des porteurs présents dans les photoconducteurs.

L'invention a également pour objet un procédé de mesure d'une impulsion brève pour lequel on utilise un dispositif selon l'invention dans lequel la ligne conductrice sur laquelle sont connectés p photoconducteurs est fermée sur son impédance caractéristique à une seule extrémité et dans lequel on envoie une impulsion électrique brève à analyser sur l'autre extrémité, une impulsion plus brève de rayonnement étant envoyée sur ces photoconducteurs en synchronisme avec l'impulsion électrique, la durée de l'impulsion de rayonnement étant sensiblement égale ou inférieure à la durée de vie des porteurs majoritaires des photoconducteurs, un ensemble de charges correspondant à un échantillonnage de l'impulsion électrique à analyser étant obtenu, chaque charge étant récupérée sur une électrode de sortie de chaque photoconducteur.

D'autres avantages et caractéristiques de l'invention apparaîtront à la lecture de la description détaillée qui suit et qui est faite en référence aux dessins annexés, dans lesquels :
- la figure 1 représente un schéma électrique du dispositif selon l'invention,
- la figure 2 représente un schéma de principe du dispositif selon l'invention, pour la mesure d'impulsions de durées différentes,
- la figure 3 représente un schéma électrique de deux éléments selon la figure 2,
- la figure 4 représente un schéma d'un exemple de réalisation d'un photoconducteur et de son positionnement dans un dispositif selon l'invention,
- la figure 5 représente un schéma classique de mesure de la durée de vie des porteurs,
- la figure 6 représente un diagramme en fonction du temps de la mesure d'une impulsion selon un deuxième et un troisième modes de fonctionnement,
- la figure 7 représente un schéma électrique du dispositif selon l'invention correspondant au troisième mode de fonctionnement selon le procédé.

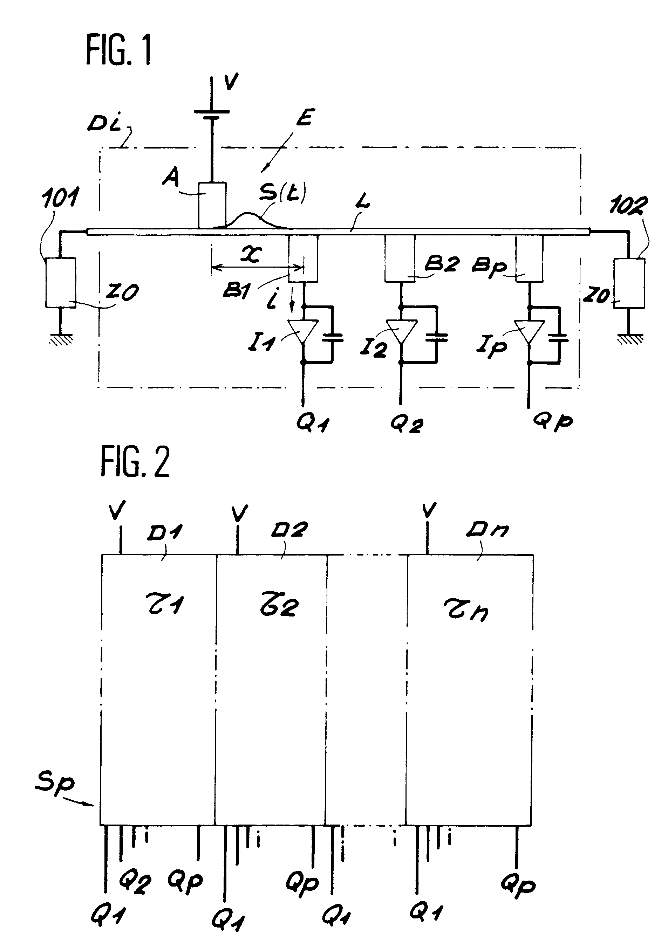

Le dispositif de mesure d'une impulsion brève est illustré sur la figure 1 par son schéma électrique. Ce dispositif de mesure comporte une ligne conductrice L fermée en ses deux extrémités 101 et 102 par son impédance caractéristique Z0. Un premier photoconducteur A est relié d'une part à cette ligne L et d'autre part à une tension de polarisation V. p photoconducteurs B1-Bp sont reliés d'une part à cette ligne L et d'autre part à des amplificateurs intégrateurs I1, I2, ..., Ip, le photoconducteur B1 étant relié à un intégrateur amplificateur I1, B2 à I2 et Bp à Ip. Le dispositif comporte également p sorties Q1-Qp, chaque sortie correspondant à une sortie d'un amplificateur intégrateur. La distance x entre chaque photoconducteur est choisie égale au produit v.(ϑ/p), dans lequel v représente la vitesse de propagation d'une onde sur la ligne L et ϑ la durée de l'impulsion à analyser E(t). La durée de vie des porteurs majoritaires constituant chaque photoconducteur, est choisie de sorte qu'elle soit inférieure ou égale à 10% de la durée ϑ. Ainsi lorsque l'on envoie une impulsion brève de rayonnement E sur les photoconducteurs, le photoconducteur A qui est polarisé par une tension prédéterminée V envoie à travers la ligne un signal électrique S(t) image de l'impulsion incidente E(t) tel que S(t) soit égal à S(t)=kE(t), le signal S(t) polarisant le second photoconducteur qui génère un courant i proportionnel au produit de convolution de l'impulsion et de son image retardée E₁(t) où E₁(t) est égal à E(t+x/v), x étant la longueur de la ligne séparant les photoconducteurs entre-eux, v la vitesse de propagation de la ligne et x étant choisi de sorte que le retard x/v soit égal à la durée ϑ/p pour obtenir p points de mesure équidistants d'une impulsion de durée ϑ. La distance entre deux photoconducteurs est donc choisie de sorte qu'elle introduise un délai égal à l'intervalle de temps voulu entre deux points successifs de l'analyse temporelle.

Le dispositif selon l'invention peut comporter un ensemble tel que celui représenté sur cette figure 1 et qui porte la référence Di, il peut également comporter selon une variante de réalisation une pluralité d'ensembles Di, i allant de 1 à n comme cela est représenté sur la figure 2. Ces ensembles sont réalisés sur un même support SP. La durée de vie des porteurs majoritaires des photoconducteurs de chaque ensemble de mesure Di sera différente d'un ensemble à un autre, on choisira par exemple une durée de vie τ1 pour l'ensemble D1, τ2> τ1 pour l'ensemble D2 et τn pour l'ensemble Dn. On choisit par exemple τ1=10 p.s pour le premier ensemble D1, τ2=20ps pour le premier ensemble D2 et τn=50 ps pour le dernier ensemble Dn. On obtient ainsi une sensibilité identique pour différentes durées d'impulsions.

Chaque ensemble a un nombre de photoconducteurs égal à p+1. Si on choisit un nombre p égal à 10, le premier ensemble donnera 10 points de mesure pour une impulsion de 100 ps alors que le deuxième ensemble donnera 5 points de mesure pour cette même impulsion, ce deuxième ensemble donnera par contre 10 points de mesure pour une impulsion de 200 ps.

Toutefois chaque ensemble de mesure ne doit pas avoir obligatoirement le même nombre de photoconducteurs.

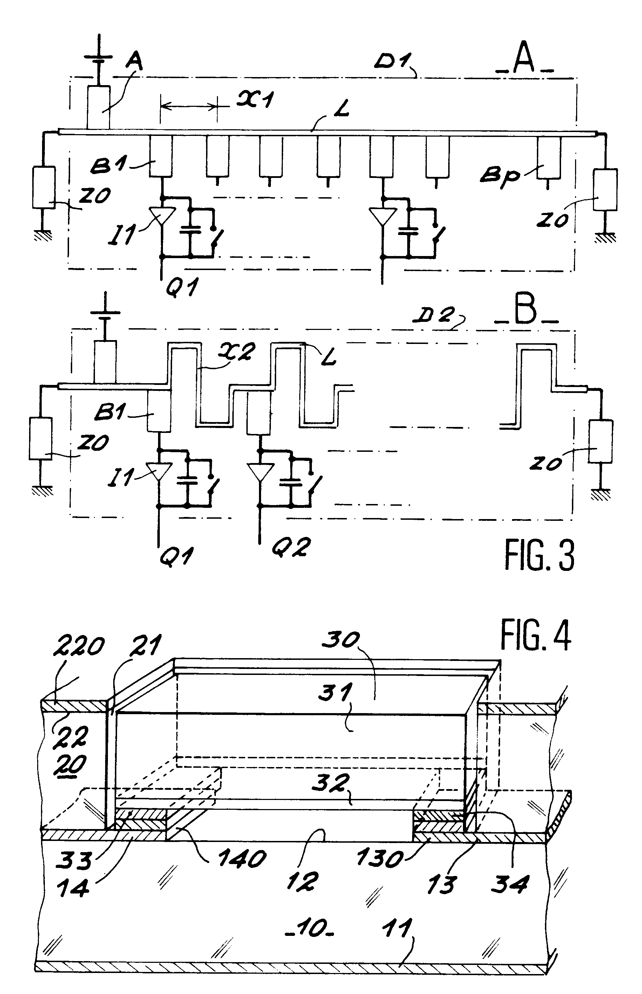

La figure 3A représente le schéma électrique d'un dispositif selon l'invention correspondant à l'ensemble D1 de la figure 2.

La figure 3B représente le schéma électrique d'un dispositif selon l'invention correspondant à l'ensemble D2 de cette même figure 2.

Sur la figure 3A, l'ensemble des photoconducteurs A, B1, B2, Bp ont une durée de vie égale à τ1 tandis que sur la figure 3B ces photoconducteurs A, B1, Bp ont des porteurs majoritaires qui ont une durée de vie égale à τ2. Le chemin électrique parcouru par le courant sur la ligne de l'ensemble D1 entre deux photoconducteurs B1, B2 ou B2, B3 ..., est égal à x1, ce chemin est égal à la longueur de la ligne entre deux photoconducteurs adjacents et est choisi égal au produit de la vitesse de propagation sur la ligne par l'intervalle de temps voulu ϑ_{A}/p entre deux points de l'analyse temporelle d'une impulsion de durée ϑ_{A}. Pour une durée de vie τ2> τ1, on aura donc des distances entre photoconducteurs x2>x1 comme on peut le voir sur la figure 3B, x2=v.(ϑ_{B}/p) pour effectuer une analyse temporelle d'une impulsion de durée ϑ_{B}. Les photoconducteurs sont choisis de manière à avoir une forte résistivité en l'absence de rayonnement (>10⁸ℓcm) afin que le dispositif présente une bonne dynamique. En effet, les charges accumulées par les sorties Qi en l'absence d'éclairement sont directement liées à la résistance des éléments photoconducteurs de type A et B considérés comme étant polarisés en série.

De plus, la sensibilité étant proportionnelle à la tension de polarisation, il est préférable d'utiliser une forte valeur pour cette tension de polarisation, une haute résistivité étant nécessaire pour assurer la bonne tenue en champ électrique.

Sur la figure 4, on a représenté la structure du dispositif selon l'invention d'après un mode de réalisation conforme à l'invention dans laquelle la ligne et les photoconducteurs se trouvent sur un même support pris entre deux diélectriques, l'un des diélectriques pouvant être un gaz ou du vide. Cette structure comprend un premier substrat 10 qui a une première face 11 entièrement métallisée, constituant un plan de masse et qui a une deuxième face 12, partiellement métallisée. Les parties métallisées constituent d'une part un ensemble de pistes 13 sur lesquelles sont connectés les amplificateurs intégrateurs I1-Ip pour former les sorties Q1, Q2, Qp de chaque ensemble telles que représentées sur les figures 3A et 3B, ces zones métallisées comportent également une piste 14 perpendiculaire aux pistes 13, cette piste 14 constitue la ligne conductrice L telle qu'on peut la voir sur les figures 3A et 3B. La piste conductrice 14 se trouve à une distance prédéterminée des extrémités des pistes 13 de manière à ce qu'il n'y ait pas de contact entre elles.

Au-dessus de ce premier substrat 10 est placé un deuxième substrat 20 qui comporte un ensemble d'orifices de longueur supérieure à l'espace qui réside entre la piste conductrice 14 et les pistes 13, de manière à ce qu'une zone 140 de la piste 14 ne soit pas recouverte pas le substrat 20 et de manière à ce qu'une zone 130 d'une piste 13 donnée, en regard avec la piste 14, ne soit également pas recouverte par ce substrat 20. La face du substrat 20 opposée à la face métallisée 12 du substrat 10 est également recouverte d'une métallisation 220. Chaque photoconducteur est réalisé de manière à avoir la forme d'un pavé 30 de dimensions telles qu'il puisse être logé à l'intérieur d'un orifice 21 du support 20. Le pavé 30 est constitué par un substrat 31 sur lequel est déposée une couche de matériau semiconducteur 32. Au-dessus de ce matériau semiconducteur et à chacune des extrémités du pavé sont réalisés un contact 33 et un contact 34. Lorsque le pavé est placé dans l'orifice, le contact 33 est posé sur la zone 140 de la piste conductrice 14 et le contact 34 est posé sur la zone 130 d'une piste 13.

Selon un exemple de réalisation conforme à l'invention, chaque unité de détection, c'est-à-dire chaque photoconducteur se présente sous la forme d'un pavé de quartz de 125 µm d'épaisseur, de 200 µm de largeur, et de 800 µm de longueur, sur lequel a été réalisé un dépôt de tellurure de cadmium de 10 µm environ d'épaisseur, les zones 140 et 130 ayant une largeur de 100 µm pour permettre le contact avec le pavé. Chacun de ces pavés est rapporté ou collé par de la laque à l'argent sur les pistes 14 et 13. Ces pistes sont réalisées par un dépôt d'une couche d'aluminium effectué sur le substrat 10 en quartz qui a une épaisseur de 125 µm, le deuxième substrat 20 est également réalisé en quartz avec une même épaisseur et est collé au-dessus des pistes à l'aide d'une résine isolante. Chaque photoconducteur est obtenu à partir d'un substrat en quartz de 20 mm x 20 mm et d'épaisseur égale à 125 µm sur lequel on dépose du tellurure de cadmium de 12 µm par une technique classique dite OMCVD (Organométallic chemical vapor déposition). Des lignes conductrices 14 sont réalisées en aluminium et ont 5 µm d'épaisseur et ont une longueur de quelques dizaines de millimètres. Après le dépôt de la couche de tellurure de cadmium, on procède à un dépôt par pulvérisation cathodique de chrome/or pour former les contacts, chaque opération s'effectue en deux temps : d'abord un dépôt de chrome de quelques centaines d'Angström pour faciliter l'accrochage de l'or, puis le dépôt d'or à proprement parler.

Afin d'obtenir les pavés aux dimensions souhaitées on découpe la plaque à l'aide d'une scie classique appropriée à ces techniques. Dans un deuxième temps, on vient positionner le pavé de quartz à l'emplacement des contacts à l'aide d'une pompe aspirante par exemple. Lorsque tous les photoconducteurs sont montés sur les supports, on recouvre l'ensemble du substrat 20 qui comprend les orifices. Pour connaître la sensibilité du dispositif réalisé, on procède à une mesure de la durée de vie des porteurs majoritaires d'un photoconducteur destiné à équiper un ensemble, les autres photoconducteurs étant réalisés de la même manière, chaque photoconducteur d'un même ensemble ayant donc des durées de vie identiques.

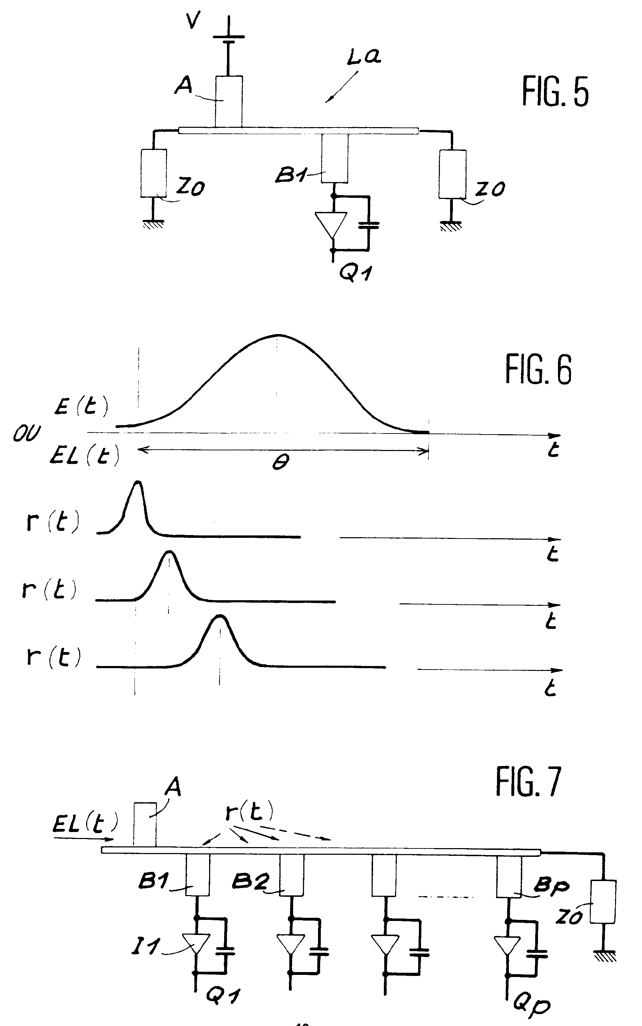

Sur la figure 5, on a schématisé un exemple particulier de montage de mesure de la durée de vie des porteurs majoritaires d'un photoconducteur destiné à équiper le dispositif de mesure. Le principe de la mesure est le suivant : on utilise, comme représenté sur cette figure, un motif élémentaire du dispositif de mesure, ce motif comprenant donc un photoconducteur A et un photoconducteur B1 reliés à la ligne L, la ligne étant fermée sur son impédance caractéristique Z0. On éclaire le motif par des impulsions laser La très brèves. La réponse à la sortie Q1 est alors directement fonction de la durée de vie des porteurs.

L'invention a également pour objet un procédé de mesure d'une impulsion brève pour lequel on utilise le dispositif qui vient d'être décrit.

Selon l'invention le dispositif permet de mesurer des points de la fonction d'autocorrélation d'une impulsion brève unique soit de rayonnement (électromagnétique ou ionisant) soit électrique. Il permet également à partir d'une seule impulsion à analyser d'obtenir le profil temporel de cette impulsion qu'elle soit issue d'un rayonnement électromagnétique ou ionisant ou d'une impulsion électrique. On obtient par ce dispositif des mesures sans problème de linéarité temporelle. Pour obtenir la fonction d'autocorrélation d'une impulsion brève de rayonnement E(t), cette impulsion est émise de sorte qu'elle éclaire le support SP qui a une structure telle que celle qui est décrite à propos de la figure 4 par exemple. L'élément Di a des photoconducteurs dont les porteurs majoritaires ont une durée de vie inférieure ou égale à 10% de la durée de l'impulsion à analyser, et va fournir p points de la fonction d'autocorrélation de cette impulsion.

Les photoconducteurs de référence A sont chacun polarisés par une tension continue. Les lignes L sont fermées en leurs extrémités sur leur impédance caractéristique Z0. Chaque photoconducteur A polarisé envoie sur la ligne L un signal électrique S(t) image de l'impulsion E(t) tel que S(t)=K.E(t) (S(t) est proportionnel à E(t)). Le signal S(t) polarise le second photoconducteur qui génère un courant i proportionnel au produit de convolution de l'impulsion et de son image retardée E₁(t), où E₁(t)=E(t+x/v). La distance x entre chaque photoconducteur est le chemin électrique parcouru par le signal S(t) c'est-à-dire la longueur de la ligne conductrice L entre chaque photoconducteur, cette longueur a été déterminée à partir de la durée de l'impulsion et du nombre de points de mesure, c'est-à-dire à partir des intervalles de temps voulus pour l'analyse. Le retard x/v est donc égal à ϑ/p. La vitesse v de propagation sur la ligne est connue. Une charge Q1, pour le photoconducteur B1, (Qi pour Bi) qui est le résultat après amplification et intégration du produit de convolution est recueillie à la sortie de chaque photoconducteur. Chaque charge recueillie correspond à la mesure d'un point de la fonction d'autocorrélation.

L'invention concerne également un procédé permettant d'effectuer une analyse temporelle d'une impulsion brève unique à partir du dispositif selon l'invention. Pour cela les photoconducteurs A sont polarisés par une tension continue. Les lignes L sont fermées sur leur impédance caractéristique Z0 aux deux extrémités. On envoie une impulsion brève de rayonnement E(t) qui éclaire tous les photoconducteurs et on envoie en synchronisme avec le front montant de l'impulsion de rayonnement une autre impulsion de rayonnement r(t) de durée extrêmement brève par rapport à la gamme de durée que peut avoir la première impulsion.

On a représenté sur la figure 6, l'impulsion E(t) et la propagation de l'image électrique sur la ligne L de l'impulsion r(t) en fonction du temps. La durée de la deuxième impulsion est inférieure ou égale à la durée de vie des porteurs des photoconducteurs du sous-ensemble considéré. Cette impulsion r(t) éclaire les photoconducteurs polarisés A. Les photoconducteurs B1-Bp sont polarisés séquentiellement par le signal se propageant sur la ligne, produit par cette impulsion très brève. On recueille aux sorties d'un élément Di du dispositif, un ensemble de charges correspondant à un échantillonnage temporel de l'impulsion de rayonnement à analyser E(t). En se propageant sur la ligne, l'impulsion la plus brève fournit, tel un stroboscope, une image exacte en p points du profil de l'impulsion à analyser.

On peut également, selon une variante, procéder de façon inverse en envoyant une impulsion très brève de rayonnement sur tous les photoconducteurs et une impulsion brève de rayonnement à analyser E(t) sur le premier photoconducteur.

L'invention concerne également un procédé permettant d'effectuer une analyse temporelle d'une impulsion brève électrique à partir du dispositif selon l'invention. Pour cela, les photoconducteurs A ne sont pas polarisés par une tension continue (ils peuvent être supprimés) et les lignes sont refermées sur leur impédance caractéristique uniquement à une extrémité comme on peut le voir sur le schéma de la figure 7. On envoie sur toutes les lignes à partir de leur extrémité libre, une impulsion brève électrique EL(t). On envoie par ailleurs en synchronisme avec le front descendant de cette impulsion électrique, une impulsion très brève de rayonnement r(t) éclairant en particulier les photoconducteurs B. La durée de cette impulsion de rayonnement très brève peut correspondre à titre d'exemple à la durée de vie des photoconducteurs du sous-ensemble considéré. Cette impulsion de rayonnement induit une fenêtre temporelle d'analyse de l'impulsion à analyser en rendant conducteurs les éléments B1-Bp. L'état de polarisation des divers éléments B1-Bp est fonction de la tension vue à ses bornes qui est directement liée à la forme de l'impulsion EL(t) se propageant dans la ligne L. On recueille aux sorties d'un élément Di tel que représenté sur la figure 7 un ensemble de charges correspondant à un échantillonnage temporel de l'impulsion électrique. L'impulsion la plus brève (de rayonnement) r(t) crée, tel un stroboscope, une image exacte, en p points du profil de l'impulsion électrique à analyser EL(t).

## Revendications

1. Dispositif de mesure d'une impulsion brève unique, comprenant au moins un ensemble de mesures (Di) apte à effectuer p points de mesure de l'impulsion de durée ϑ, comportant une ligne conductrice (L) et un ensemble de photoconducteurs (A, B1-Bp), la ligne (L) et les photoconducteurs (A, B1-Bp) étant placés entre deux diélectriques, caractérisé en ce qu'à la ligne (L) est relié par une de ses électrodes chacun des photoconducteurs de l'ensemble de photoconducteurs (A, B1-Bp), la longueur de la ligne (L) séparant deux photoconducteurs successifs (B1, B2) (B2, B3) est égale au produit de la vitesse de propagation v sur cette ligne (L) par le rapport ϑ/p, les photoconducteurs (A, B1-Bp) étant choisis de sorte que la durée de vie τ des porteurs majoritaires constituant ces photoconducteurs (A, B1-Bp) soit inférieure ou égale à 10% de la durée ϑ de l'impulsion à analyser, le dispositif permettant ainsi d'introduire un délai entre chaque photoconducteur (A, B1-Bp) égal à l'intervalle de temps voulu entre deux points de mesure successifs de l'impulsion à analyser afin d'obtenir une analyse temporelle ou la fonction d'autocorrélation, soit d'une impulsion de rayonnement, soit d'une impulsion électrique.

2. Dispositif de mesure d'une impulsion selon la revendication 1, caractérisé en ce qu'il comporte une pluralité d'ensembles de mesure (D1-Dn) pour lesquels, la durée de vie des porteurs majoritaires des photoconducteurs est différente d'un ensemble à un autre, chacun étant apte à effectuer p points de mesure d'une impulsion de durée déterminée.

3. Dispositif de mesure d'une impulsion brève selon l'une quelconque des revendications 1 ou 2, caractérisé en ce que chaque ensemble de mesure (Di) comporte p+1 photoconducteurs dont la durée de vie τ des porteurs majoritaires est inférieure ou égale à 10% de ϑ de manière à avoir p points de mesure pour une impulsion de durée égale à ϑ.

4. Dispositif de mesure d'une impulsion brève selon l'une quelconque des revendications 1 à 3, caractérisé en ce qu'il comporte un premier substrat (10) comportant une première face métallisée (11) et sur une deuxième face (12) oppossée à la première, un ensemble de pistes conductrices (13) et une ligne conductrice (14) sensiblement perpendiculaire aux pistes et espacées de ces dernières, un deuxième substrat (20) placé sur les pistes (13) et la ligne conductrice (14), ce deuxième substrat (20) comprenant des orifices (21) de longueur supérieure à l'espace qui réside entre la ligne conductrice et les pistes et étant recouvert d'une couche métallique (220), les photoconducteurs étant constitués par des pavés (30) comportant un substrat (31) sur lequel est déposée une couche semiconductrice (32) puis un premier (33) et deuxième (34) contacts placés sur la couche semi-conductrice à chacune des extrémités du pavé, chaque pavé ayant des dimensions telles qu'il puisse être logé dans un orifice (21) du deuxième substrat (20), un contact étant placé sur la ligne (14) tandis que l'autre est placé sur une desdites pistes (13).

5. Dispositif de mesure d'une impulsion brève selon l'une quelconque des revendications 1 à 4, caractérisé en ce que la couche semiconductrice (32) constituant chaque photoconducteur est constituée par du tellurure de cadmium (CdTe) ou de l'arséniure de gallium ou du phosphure d'indium.

6. Procédé de mesure d'une impulsion pour lequel on utilise un dispositif de mesure selon l'une quelconque des revendications 1 à 5, caractérisé en ce que, la ligne conductrice étant fermée à chacune de ses extrémités par son impédance caractéristique, on envoie une impulsion brève de rayonnement, le premier photoconducteur étant polarisé par une tension continue prédéterminée, envoie à travers la ligne un signal électrique S(t) image de l'impulsion incidente E(t) tel que S(t)=k.E(t), le signal S(t) polarisant le second photoconducteur qui génère un courant i proportionnel au produit de convolution de l'impulsion et de son image retardée E₁(t) ou E₁(t)=E(t+x/v), x étant la longueur de la ligne séparant ces deux premiers photoconducteurs, v la vitesse de propagation sur la ligne, x étant choisi de sorte que le retard x/v soit égal à ϑ/p, avec des photoconducteurs dont la durée de vie des porteurs majoritaires est inférieure ou égale à 10% de ϑ, le signal S(t) polarisant de la même façon successivement tous les autres photoconducteurs avec un retard augmenté à chaque fois de ϑ/p, une charge Qi résultat de ces produits de convolution étant recueillie à la sortie de chaque photoconducteur, excepté le premier chaque charge donnant ainsi la mesure d'un point de la fonction d'autocorrélation de l'impulsion à mesurer.

7. Procédé de mesure d'une impulsion pour lequel on utilise un dispositif de mesure selon l'une quelconque des revendications 1 à 5, caractérisé en ce que, la ligne conductrice étant fermée en ses deux extrémités par son impédance caractéristique, on envoie une impulsion brève de rayonnement à analyser éclairant tous les photoconducteurs et en synchronisme avec cette impulsion, une impulsion de rayonnement plus brève de durée inférieure ou égale à la durée de vie τ, sur le premier photoconducteur, ce photoconducteur étant polarisé par une tension continue prédéterminée ; un ensemble de charges correspondant à un échantillonnage temporel de l'impulsion de rayonnement à analyser est obtenu, chaque charge étant récupérée sur une électrode de sortie de chaque photoconducteur excepté le premier.

8. Procédé de mesure selon la revendication 7, caractérisé en ce que l'on envoie l'impulsion brève de rayonnement à analyser sur le premier photoconducteur et l'impulsion plus brève de durée inférieure ou égale à τ sur tous les photoconducteurs.

9. Procédé de mesure d'une impulsion pour lequel on utilise un dispositif de mesure selon l'une quelconque des revendications 1 à 5, caractérisé en ce que, la ligne conductrice sur laquelle sont connectés p photoconducteurs, étant fermée sur son impédance caractéristique à une seule extrémité, on envoie une impulsion électrique brève à analyser sur l'autre extrémité ; une impulsion plus brève de rayonnement étant envoyée sur ces photoconducteurs en synchronisme avec le front descendant de l'impulsion électrique, un ensemble de charges correspondant à un échantillonnage de l'impulsion électrique à analyser est obtenue, chaque charge étant récupérée sur une électrode de sortie de chaque photoconducteur.

## Patentansprüche

1. Vorrichtung zum Messen eines einmaligen kurzen Impulses, die wenigsten eine Meßanordnung (Di), die geeignet ist, p Meßpunkte des Impulses von der Dauer ϑ zu bilden und eine Leiterbahn (L) umfaßt, und eine Anordnung von Photoleitern (A, B1-Bp) umfaßt, wobei die Leitung (L) und die Photoleiter (A, B1-Bp) zwischen zwei Dielektrika angeordnet sind, dadurch gekennzeichnet, daß jeder der Photoleiter der Anordnung von Photoleitern mit der Leitung (L) über einen ihrer elektrischen Knoten (A, B1-Bp) verbunden ist, und daß die Länge der Leitung (L), die zwei aufeinanderfolgende Photoleiter (B1, B2) (B2, B3) trennt, gleich dem Produkt der Propagationsgeschwindigkeit v auf dieser Leitung (L) mit dem Verhältnis ϑ/p ist, wobei die Photoleiter (A, B1-Bp) so ausgewählt sind, daß die Lebensdauer τ der Majoritätsladungsträger, die diese Photoleiter (A, B1-Bp) bilden, kleiner oder gleich 10% der Dauer ϑ des zu analysierenden Impulses ist, wobei die Vorrichtung somit erlaubt, zwischen jedem Photoleiter (A, B1-Bp) eine Verzögerung gleich dem gewünschten Zeitintervall zwischen zwei aufeinanderfolgenden Meßpunkten des zu analysierenden Impulses einzuführen, um eine Zeitanalyse oder die Autokorrelationsfunktion entweder eines Leuchtimpulses oder eines elektrischen Impulses zu erhalten.

2. Vorrichtung zum Messen eines Impulses nach Anspruch 1, dadurch gekennzeichnet, daß sie eine Mehrzahl von Meßanordnungen (D1-Dn) umfaßt, für die die Lebensdauer der Majoritätsladungsträger der Photoleiter von einer Anordnung zur anderen verschieden ist, wobei jede Anordnung geeignet ist, p Meßpunkte eines Impulses gegebener Dauer zu erhalten.

3. Vorrichtung zum Messen eines Impulses nach einem der Ansprüche 1 oder 2, dadurch gekennzeichnet, daß jede Meßanordnung (Di) p+1 Photoleiter umfaßt, deren Majoritätsladungsträgerlebensdauer τ kleiner oder gleich 10% von ϑ ist, um p Meßpunkte für einen Impuls der Dauer ϑ zu erhalten.

4. Vorrichtung zum Messen eines Impulses nach einem der Ansprüche 1 bis 3, dadurch gekennzeichnet, daß sie ein erstes Substrat (10) mit einer ersten metallisierten Oberfläche (11) und auf einer zweiten Oberfläche (12) gegenüber der ersten Oberfläche mit einer Anordnung von Leiterbahnen (13) und einer elektrischen Leitung (14) im wesentlichen senkrecht zu den Bahnen und von diesen getrennt und ein zweites Substrat (20) umfaßt, das auf den Bahnen (13) und der Leitung (14) angeordnet ist, wobei das zweite Substrat (20) Öffnungen (21) von einer Länge größer als der Zwischenraum, der zwischen der Leitung und den Bahnen besteht, umfaßt und mit einer metallischen Schicht (220) bedeckt ist, wobei die Photoleiter aus Punkten (30) bestehen, die ein Substrat (31) umfassen, auf dem eine halbleitende Schicht (32), dann ein erster (33) und ein zweiter, auf der halbleitenden Schicht an jedem Ende des Punktes aufgebrachter Kontakt abgeschieden ist, wobei jeder Punkt solche Ausmaße besitzt, daß er in einer Öffnung (21) des zweiten Substrats (20) angeordnet werden kann, wobei ein Kontakt auf der Leitung (14) und der andere auf einer der Bahnen (13) angeordnet wird.

5. Vorrichtung zum Messen eines Impulses nach einem der Ansprüche 1 bis 4, dadurch gekennzeichnet, daß die halbleitende Schicht (32), die den Photoleiter bildet, aus Cadmiumtellurit (CdTe) oder aus Galliumarsenid oder aus Indiumphosphit besteht.

6. Verfahren zum Messen eines Impulses, für das man eine Meßvorrichtung nach einem der Ansprüche 1 bis 5 verwendet, dadurch gekennzeichnet, daß, während die Leitung an jedem ihrer Enden durch ihre charakteristische Impedanz abgeschlossen ist, man einen kurzen Strahlungsimpuls sendet, wobei der erste Photoleiter von einer vorgegebenen Gleichspannung polarisiert wird, man durch die Leitung ein elektrisches Signal S(t) als Bild des einfallenden Impulses E(t) derart, daß S(t)=k·E(t), schickt, wobei das Signal den zweiten Photoleiter polarisiert, der einen Strom i gleich der Faltungsprodukt des Impulses und seines verzögerten Bildes E₁(t), wobei E₁(t)=E(t+x/v), erzeugt, wobei x die Länge der diese beiden Photoleiter trennenden Leitung ist, v die Propagationsgeschwindigkeit auf der Leitung ist und x derart ausgewählt ist, daß x/v gleich ϑ/p ist, mit Photoleitern, deren Majoritätsladungsträgerlebensdauer kleiner oder gleich 10% von ϑ ist, wobei das Signal S(t) auf gleiche Weise der Reihe nach alle anderen Photoleiter mit einer jedes Mal um ϑ/p vergrößerten Verzögerung polarisiert, wobei eine Ladung Qi als Ergebnis dieser Faltungsprodukte am Ausgang jedes Photoleiters außer dem ersten erhalten wird, wobei jede Ladung die Messung eines Punktes der Autokorrelationsfunktion des zu messenden Impulses gibt.

7. Verfahren zum Messen eines Impulses, für das man eine Meßvorrichtung nach einem der Ansprüche 1 bis 5 verwendet, dadurch gekennzeichnet, daß, während die Leitung an jedem ihrer Enden durch ihre charakteristische Impedanz abgeschlossen ist, man einen kurzen, zu analysierenden Strahlungsimpuls sendet, der alle Photoleiter beleuchtet, und synchron zu diesem Impuls einen kürzeren Strahlungsimpuls mit einer Dauer kleiner oder gleich der Lebensdauer τ auf den ersten Photoleiter sendet, wobei dieser Photoleiter von einer vorgegebenen Gleichspannung polarisiert ist; daß eine Anordnung von Ladungen, die einer zeitlichen Abtastung des zu analysierenden Strahlungsimpulses entspricht, erhalten wird, wobei jede Ladung auf einer Ausgangselektrode jedes Photoleiters außer des ersten erhalten wird.

8. Verfahren nach Anspruch 7, dadurch gekennzeichnet, daß man den kurzen, zu analysierenden Strahlungsimpuls auf den ersten Photoleiter und den kürzeren Impuls mit einer Dauer kleiner oder gleich τ auf alle Photoleiter schickt.

9. Verfahren zum Messen eines Impulses, für das man eine Meßvorrichtung nach einem der Ansprüche 1 bis 5 verwendet, dadurch gekennzeichnet, daß, während die Leitung, mit der p Photoleiter verbunden sind, nur an einem Ende mit ihrer charakteristischen Impedanz abgeschlossen ist, man einen kurzen zu analysierenden, elektrischen Impuls zum anderen Ende schickt, wobei ein kürzerer Strahlungsimpuls auf diese Photoleiter synchron mit der abfallenden Flanke des elektrischen Impulses gesandt wird; daß eine Anordnung von Ladungen, die einer Abtastung des zu analysierenden elektrischen Impulses entspricht, erhalten wird, wobei jede Ladung auf einer Ausgangselektrode jedes Photoleiters außer des ersten erhalten wird.

## Claims

1. Device for measuring a single short pulse comprising at least one set of measurements (Di) suitable for carrying out p measurement points of the pulse of duration ϑ comprising a conductive line and a set of photoconductors (A,B1-Bp), the line (L) and the photoconductors (A,B1-Bp) being placed between two nonconductors, characterized in that to the line (L) is connected by one of its electrodes each of the photoconductors of the set of photoconductors (A,B1-Bp), the length of the line (L) separating two successive photoconductors (B1,B2;B2,B3) being equal to the product of the propagation speed on this line (L) by the ratio ϑ/p, the photoconductors (A,B1-Bp) being selected so that the lifetime τ of the majority carriers constituting these photoconductors (A,B1-Bp) is less than or equal to 10% of the period ϑ of the pulse to be analysed, the device thus making it possible to introduce a delay between each photoconductor (A,B1-Bp) equal to the desired time interval between two successive measuring points of the pulse to be analysed so as to obtain a time analysis or the autocorrelation function of either a radiation pulse or an electric pulse.

2. Pulse measuring device according to claim 1, characterized in that a plurality of measuring units (Dl-Dn) for which the lifetime of the majority carriers of the photoconductors differs from one unit to another, each being suitable for carrying out p measurement points of a pulse of determined duration.

3. Short pulse measuring device according to claims 1 or 2, characterized in that each measuring unit (Di) comprises p+1 photoconductors, the lifetime τ of the majority carriers being less than or equal to 10% of ϑ so as to have p measuring points for a pulse whose duration is equal to ϑ.

4. Short pulse measuring device according to any one of the claims 1 to 3, characterized in that it has a first substrate (10) comprising a first metallized face (11) and, on a second face (12) opposite the first one, a set of conductive tracks (13) and a conductive line (14) roughly perpendicular to the tracks and spaced from the latter, a second substrate (20) being placed on the tracks (13) and the conductive line (14), this second substrate (20) including openings (21), whose length is greater than the space existing between the conductive line and the tracks, and being coated with a metallic coating (220), the photoconductors being constituted by blocks (30) comprising a substrate (31) on which is deposited a semiconductive coating (32) and then a first (33) and a second (34) contact placed on the semiconductive coating at each of the extremities of the block, each block having dimensions making it possible for it to be housed inside an opening (21) of the second substrate (20), one contact being placed on the line (14), the other being placed on one of said tracks (13).

5. Short pulse measuring device according to any one of the claims 1 to 4, characterized in that the semiconductive coating (32) constituting each photoconductor consists of cadmium telluride (CdTe) or gallium arsenide or indium phosphide.

6. Pulse measuring method using a measuring device according to any one of the claims 1 to 5, characterized in that the conductive line being closed at each of its extremities by virtue of its characteristic impedance, of transmitting a short radiation pulse, the first photoconductor being polarized bg a predetermined d.c. voltage, of transmitting through the line an image electric signal S(t) of the incident pulse E(t) so that S(t)=k.E(t), the signal S(t) polarizing the second photoconductor which generates a current proportional to the convolution product of the pulse and its delayed image E₁(t) or E₁(t)=E(t+x/v), x being the length of the line separating these two photoconductors, v the propagation speed on the line, x being selected so that the delay is equal to ϑ/p, with photoconductors bearing majority carriers whose lifetime is less than or equal to 10% of ϑ, the signal successively polarizing in the same way all the other photoconductors with a delay increased each time by ϑ/p, a load resultant of these convolution products being collected at the output of each photoconductor except for the first one, each load thus providing the measurement of a point of the autocorrelation function of the pulse to be measured.

7. Pulse measuring method using a measuring device according to any one of the claims 1 to 5, characterized in that the conductive line being closed at its two extremities bg virtue of its characteristic impedance, of transmitting a short radiation pulse to be analysed lighting all the photoconductors and of transmitting in synchronism with this pulse a shorter radiation pulse whose duration is less than or equal to the lifetime τ concerning the first photoconductor, this photoconductor being polarized bg a predetermined d.c. voltage ; and of thus obtaining a set of loads corresponding to a time sampling of the radiation pulse to be analysed, each load being recovered on an output electrode of each photoconductor, except the first one.

8. Measurement method according to claim 7, characterized in that said short radiation pulse to be analysed is transmitted to the first photoconductor and said shorter pulse, whose duration is less than or equal to τ, to all the photoconductors.

9. Pulse measuring method using a measuring device according to any one of the claims 1 to 5, characterized in that the conductive line connected to p photoconductors being closed on its characteristic impedance at a single extremity, a short electric pulse to be analysed is transmitted to the other extremity a shorter radiation pulse being sent onto these photoconductors in synchronism with the descending front part of the electric pulse, a set of loads corresponding to a sampling of the electric pulse to be analysed being obtained, each load being recovered on one output electrode of each photoconductor.
